# EUROPEAN PATENT APPLICATION

(11) **EP 4 579 249 A1**
(43) Date of publication of application: **02.07.2025**
(21) Application number: 24222312.1
(22) Date of filing: 20.12.2024
(51) Int. Cl.: G01R 19/25, G01R 21/133, F17D 5/08

(54) **SYSTEMS, APPARATUSES, AND METHODS TO IDENTIFY INDUCED CURRENT IN PIPELINES**

(30) Priority: 28.12.2023 US 202363615714 P
(71) Applicant: GPT Industries, LLC, Wheat Ridge, Colorado 80033-2244 (US)
(72) Inventor: GONZALES, Gabriel, Las Cruces, 88005 (US)
(74) Representative: J A Kemp LLP

(57) **Abstract**

The technology of the present application provides a method, apparatus, and non-transitory medium to identify induced voltages and/or currents on a pipeline. The technology includes a monitor and process assembly that receives a first signal indicative of at least a voltage or current on a pipeline. The assembly calculates a root mean square (RMS) and an average for the first signal, which RMS and averages are collected as time domain data. The time domain data is transformed to the frequency domain, by a Fourier transformation, which is displayed to determine if a voltage or current signal is on the pipeline.

## Description

### CROSS-REFERENCE TO RELATED PATENT APPLICATIONS

This application claims the benefit of co-pending U.S. Provisional Patent Application No. 63/615,714, filed December 28, 2023, the entire contents of which are incorporated by reference.

### BACKGROUND

The technology of the present application relates generally to protection of pipelines and personnel and, more particularly, to systems, apparatuses, and methods to identify induced current in pipelines.

Pipelines, generally buried but sometimes raised, are used to transport fluids. The fluids, such as oil and natural gas, are often transported over large swathes of remote land. In some instances, the land is owned by citizens or corporations of a country. In the United States, for example, the pipelines are allowed to be placed on privately owned land using easements or right of ways.

Public utility easements, or right of ways, in many instances include overhead or buried electric power transmission lines as well as buried or raised pipelines. The electric power transmission lines carry high voltage electricity, typically using an alternating current such as 60 Hz (North America) or 50 Hz (Europe).

The pipelines are generally made of a conductive metal, such as steel. The conductive metal in the vicinity of the high voltage electric power transmission lines can result in induced voltages and currents in the metal pipelines. The induced voltages and currents (generically referred to as induced current or currents) can cause corrosion in the metal pipelines and presents a potential hazard to life (people and/or wildlife) due to electrical shock if the induced current is not mitigated. To avoid or reduce the potential corrosion and/or hazards, pipelines are required to mitigate against induced currents. Traditionally, it is difficult to identify induced current in a pipeline and, as such, without knowledge of induced current, if any, it is difficult to evaluate the effectiveness of any associated mitigation attempts.

Thus, against this background, it would be desirable to provide a systems, apparatuses, and methods to identify induced current in pipelines.

### SUMMARY

This Summary is provided to introduce a selection of concepts in a simplified form that are further described below in the Detailed Description. This Summary, and the foregoing Background, is not intended to identify key aspects or essential aspects of the claimed subject matter. Moreover, this Summary is not intended for use as an aid in determining the scope of the claimed subject matter.

In some aspects of the technology, methods to identify induced currents on a pipeline are provided. The methods include receiving, at a monitor and process assembly a first signal indicative of at least a voltage or current on a pipeline. Calculating, by the monitor and process assembly, a root mean square of the first signal. Calculating, by the monitor and process assembly, an average of the first signal. Collecting at least a first time domain data set of the root mean square and the average of the first signal and transforming, by the monitor and process assembly, the first time domain data set to a first frequency domain data set such that the first frequency domain data set may be displayed.

In some aspects of the technology, monitoring systems to identify induced currents on a pipeline are provided. The systems include a monitoring system for identifying currents on a pipeline, the system comprising a monitor and process assembly configured to receive signals from a pipeline, where the monitor and process assembly include a receiver, a processor, and a memory. The receiver is configured to receive a first signal indicative of at least one of a voltage or a current from a pipeline. The processor and memory configured to perform the following functions: calculating a root mean square of the first signal; calculating an average of the first signal; collecting at least a first time domain data set of the root mean square and the average of the first signal transforming, by the monitor and process assembly, the first time domain data set to a first frequency domain data set; and displaying the first frequency domain data set.

In some aspects of the technology, one or more non-transitory computer-readable storage media having stored thereon instructions that, when executed by one or more processors, cause the one or more processor to perform operations comprising: sampling a first signal indicative of at least one of a voltage or a current on a pipeline; calculating a root mean square of the first signal; calculating an average of the first signal; collecting at least a first time domain data set of the root mean square and the average of the first signal transforming the first time domain data set to a first frequency domain data set; and displaying the first frequency domain data set.

These and other aspects of the present system and method will be apparent after consideration of the Detailed Description and Figures herein.

### BRIEF DESCRIPTION OF THE DRAWINGS

Non-limiting and non-exhaustive embodiments of the present invention, including the preferred embodiment, are described with reference to the following figures, wherein like reference numerals refer to like parts throughout the various views unless otherwise specified.
Figure 1 is a schematic line diagram of a monitor and process apparatus operationally coupled to a buried pipeline to monitor for induced currents consistent with the technology of the present application.
Figure 2 is a half cycle sine wave signal showing sampling of induced currents on the pipeline consistent with the technology of the present application.
Figure 3 is a full cycle of the sine wave of figure 2 showing peak, root mean square, and average values consistent with the technology of the present application.
Figure 4 is a time domain exemplary voltage and current analog graph of induced currents on the pipeline of figure 1 showing both with and without cathodic protection systems.
Figure 5 is a frequency domain conversion of figure 4.
Figure 6 shows cycles of a cathodic protection system power input signal and the results of using a half wave rectifier or full wave rectifier to convert the AC input to a DC output consistent with the technology of the present application.
Figures 7-13 are time domain and frequency domain plots of an exemplary pipeline with induced currents consistent with the technology of the present application.
Figure 14 is a diagram of a machine configured to perform the functions, data collection, and conversions consistent with the technology of the present application.

### DETAILED DESCRIPTION

The technology of the present application will now be described more fully below with reference to the accompanying figures, which form a part hereof and show, by way of illustration, specific exemplary embodiments. These embodiments are disclosed in sufficient detail to enable those skilled in the art to practice the technology of the present application. However, embodiments may be implemented in many different forms and should not be construed as being limited to the embodiments set forth herein. The following detailed description is, therefore, not to be taken in a limiting sense.

The technology of the present application is described with specific reference to systems, apparatuses, and methods to identify induced currents in metal pipelines from electrical power lines. However, the technology described herein may be used with applications other than those specifically described herein. For example, the technology of the present application may be applicable to the identification of induced current due to a grounding fault, a direct electrical connection (such as a short), a geomagnetic influence, other sources of induced current, identifying induced current in conductive pipelines formed from material other than metal, or the like. Moreover, the technology of the present application will be described with relation to exemplary embodiments. The word "exemplary" is used herein to mean "serving as an example, instance, or illustration." Any embodiment described herein as "exemplary" is not necessarily to be construed as preferred or advantageous over other embodiments. Additionally, unless specifically identified otherwise, all embodiments described herein should be considered exemplary.

Induced current and stray current is a common problem that occurs when conductive material is installed near electric power transmission lines, other high voltage sources, a grounding fault, an electrical current generator connected to the pipeline, railway electrical power lines, or a strong geomagnetic field(s). The main concerns with the induced current are corrosion, especially with buried pipelines, and electric shock to life. Ironically, newer metal pipelines are buried with a protective coating to inhibit corrosion. The coating is a dielectric material to inhibit electrical conduction between the metal (or conductive) pipeline and the soil, which limits the corrosion. The coating, however, causes more electrical build up on the pipeline, which could increase danger to life.

Due in part to the safety concerns relating to electric shock, mitigation of induced currents on metal pipelines is regulated. For example, the National Association of Corrosion Engineers (NACE) has promulgated a standard SP0177-2019 through the American National Standards Institute relating to the "Mitigation of Alternating Current and Lighting Effects on Metallic Structures and Corrosion Control Systems" ("SP0177-2019") that includes sections on personnel protection and mitigation requirements. SP01177-2019 is incorporated herein by references as if set out in full for all purposes. While the 2019 version of the SP01177 is incorporated specifically, the standard is updated from time to time, which future updates are incorporated herein as well.

However, it is often difficult to identify induced currents on pipelines, especially when they are buried pipelines. In these instances, it is difficult to know whether mitigation of any induced currents is necessary or effective. Also, .as mentioned, pipelines are generally subject to corrosion. While there are several methods and ways to protect pipelines from corrosion, one common protection mechanism is a cathodic protection system. A cathodic protection applies an electric current to the pipeline to inhibit corrosion. The electric current is typically a rectified (half or full wave signal rectified) current that converts an alternating current to a direct current. The cathodic protection system includes the electric current source, such as the rectifier, a sacrificial metal (anode), and the pipeline (cathode). With cathodic protection systems, the sacrificial metal (anode) corrodes rather than the pipeline (cathode). The application of the electric current to the pipeline line as part of the cathodic protection system, however, can make identifying other induced currents additionally difficult.

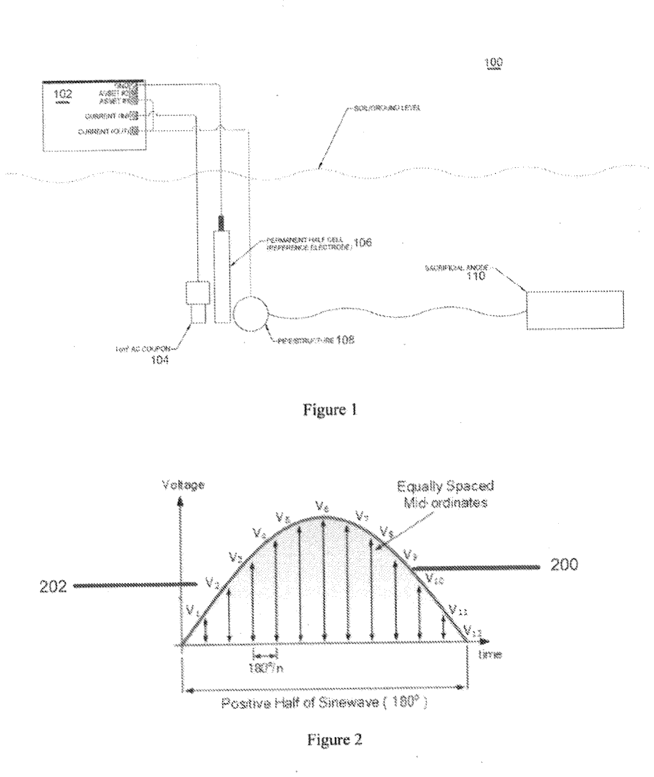

With reference to figure 1, a monitoring system 100 for measuring, displaying, and identifying induced currents in a pipeline is shown. The monitoring system 100 includes a monitor and process assembly 102, an AC coupon 104, a reference electrode 106 (also known as a permanent half-cell), a conductive asset 108 (which is also referred to as the pipeline 108), and a sacrificial anode 110. The monitoring system 100 does not need the sacrificial anode 110, but the present monitoring system 100 is described with a cathodic protection system in place for completeness. In this case, the pipeline 108 and the sacrificial anode 110 are buried. As explained above, the pipeline 108 and sacrificial anode will be electrically coupled in a cathodic protection system, not specifically shown, that applies a DC current (typically from a rectifier) to the sacrificial anode 110 and the pipeline 108 such that corrosion more readily occurs on the sacrificial anode 110. While other metals are possible, the pipelines are generally formed from steel and the sacrificial anodes are generally formed from zinc, aluminum, magnesium, or the like.

The monitor and process assembly 102, in this exemplary embodiment, is coupled to monitor both voltage and current on the pipeline 108. In certain applications of the technology described herein, the monitor and process assembly 102 may monitor only the voltage or only the current. The monitor and process assembly 102 has a ground terminal 112 coupled to the reference electrode 106. The monitor and process assembly 102 has a current output terminal 114 coupled to the ac coupon 104. The monitor and process assembly 102 has as asset (pipeline) terminal 116 coupled to both the current output terminal 120 and the pipeline 108.

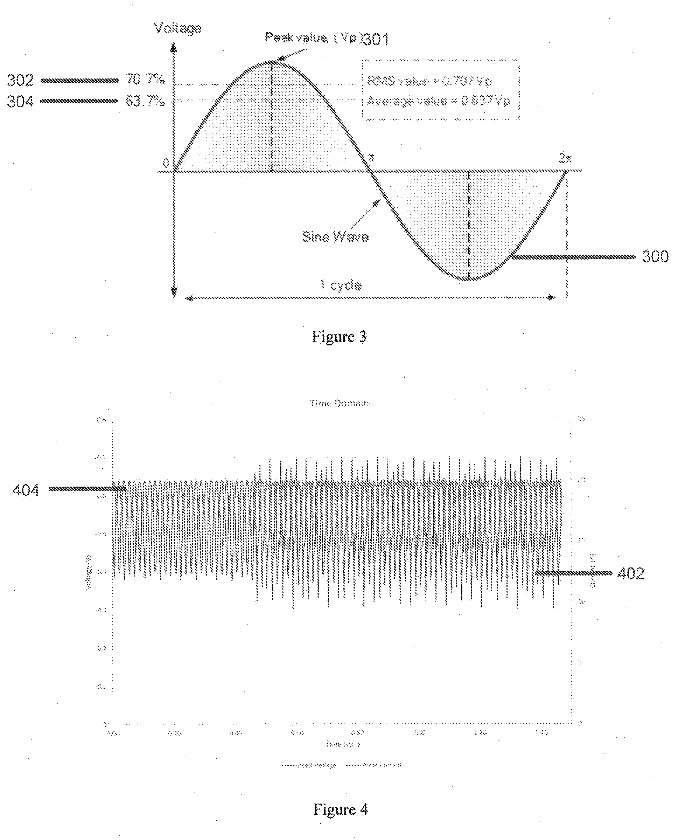

As can be appreciated, the voltage and current on the pipeline 108 are analog signals receivable by the monitor and process assembly 102. Figure 2 shows an exemplary analog signal 200, which is a ½ cycle sine wave, that may be present on the pipeline 108. An analog-to-digital converter (ADC) in the monitor and process assembly 102 is used to digitize the samples voltages 202 from the analog signal 200, which may result in, for example, a plurality of signals 202ₙ, which may include voltage and current amplitudes, among other measurements over the period of the signal (which is only shown over the positive ½ of voltage signal). The ADC does not need to be located with the monitor and process assembly 102. In certain aspects, the leads may preprocess the analog signals and send digitized readings to the monitor and process assembly 102. While 12 voltage samples 202 are shown as being taken over the ½ wave cycle, more or less samples may be taken. Figure 3 shows a full cycle signal 300 of an exemplary analog signal with a peak amplitude 301. Using the sampled signals 202, the monitor and process assemble and calculate the root mean square (RMS) voltage 302, which more accurately is the true root mean square voltage (TRMS), and the average volage 304, for example. As shown in figure 3, for an undistorted AC signal, such as the exemplary signals 200 and 300, the TRMS is about 70.7% of the peak voltage and the average voltage is about 63.7% of the peak voltage (or Vₚ). The ratio of the TRMS and average voltage for undistorted signals 200 and 300 is 1.11. If the ratio of the RMS value/ the average value is not 1.11 (or within a tolerance), the analog signal on the pipeline 108 may be considered distorted. The distorted signal may be due to induced current on the pipeline 108. The ratio may be used as a standard reading of whether the pipeline signal is or is not distorted. For example, the monitor and process assembly 102 may transmit an induced current detected signal to a display if the ratio is outside a predetermined tolerance from 1.11, For example, the monitor and process assembly 102 may calculate the ratio of TRMS/average voltage. Once the ratio is calculated, the monitor and process assembly 102 may determine that ratio is equal to 1.11. The ratio being equal to 1.11 is generally useful as a test for whether there is any distortion. In certain aspects, the technology may provide a tolerance for when the ratio is acceptable even if the ratio is not exactly 1.11. A ratio equal to 1.11 (or within the accepted tolerance) generally means the signal is undistorted (or reasonably undistorted), which may indicate mitigation is effective or no mitigation is needed. A distorted signal generally signals that there is a source inducing current onto the pipeline, which may need to be identified. In some aspects, the induced current can be correlated to known sources, and in other aspects, the induced current source would need to be investigated as it may be unknown. In some cases, once the ratio is calculated, the monitor and process assembly 102 may determine that the ratio indicates a distortion on the asset, which may indicate that induced current is on the pipeline and mitigation is required (or additional mitigation is required). The calculated ratio and the determination of effective (or not) mitigation may be displayed on a display 122. The display 122 may be a display monitor on the monitor and process assembly 102. The display 122 may be a graphical user interface (GUI) on the monitor and process assembly 102. The display 122 may be a remote monitor operationally coupled to the monitor and process assembly 102, which could be a smart device, such as a smartphone or the like. Additionally, if mitigation is not effective a warning may be displayed on display 122 or transmitted to another remote device, such as a control center, smart device, or the like. Although useful, the analog signal on the pipeline and the measuring of the same is subject to many influences, including noise and changing environmental conditions, that cause the TRMS value/average value ratio not to be 1.11 (and possibly outside of the set tolerance conditions). For example, figure 4 shows a voltage signal 402 and a current signal 404 on the pipeline 108 over a time period. The signals 402 and 404 are distorted signals with differing peaks and troughs over time. Thus, the ratio (generally referred to as a standard reading herein) may provide a spot or real-time indication that the signal on the pipeline is distorted (or not), the ratio determination is often no more than a notification that the pipeline 108 may have induced currents and further investigation is required.

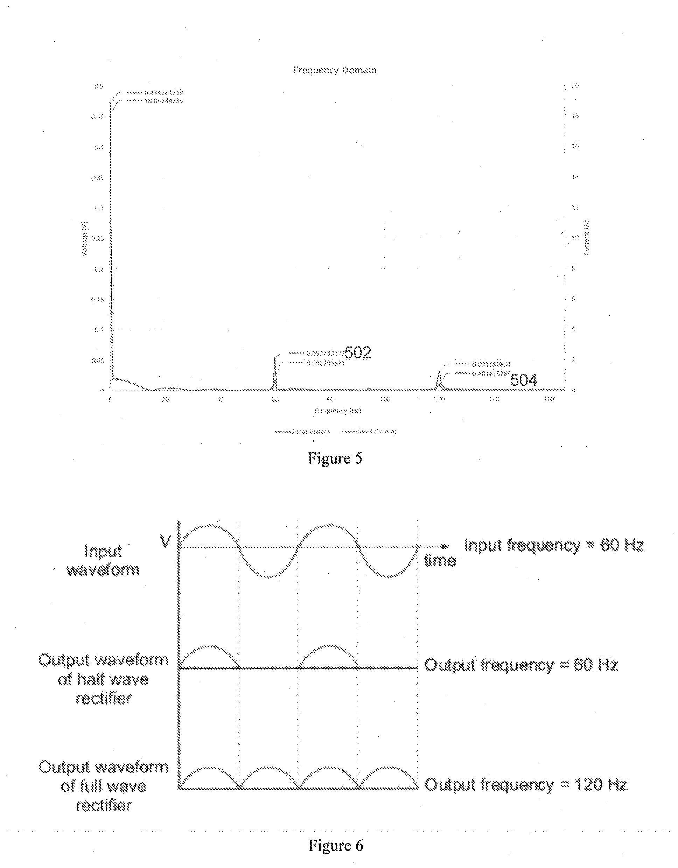

The monitor and process assembly 102, or a server operationally coupled to the monitor and process assembly 102 when scheduled, may perform a Fourier transformation (or a fast Fourier transformation) on the digitized signals received by the monitor and process assembly 102. A Fourier transformation signal 502 (voltage) and 504 (current) is shown in figure 5. The Fourier transformation signals 502, 504 show voltage/current peaks at low frequency (around 0 to about 17Hz), at about 60 Hz, and at about 120 Hz. These peaks coincide with induced currents, which are generally less than 1 Hz in frequency, and electrical power transmission cables, which in the US transmits power over electrical power transmission cables at about 60 Hz. These peaks may be at different frequencies for other countries, such as 50 Hz in Europe. Other peaks are possible due to other potential induced current sources and peaks at 60 and 120 Hz is exemplary only.

As mentioned above, however, the pipeline of the present exemplary embodiment shown in figure 1 has the cathodic protection system operationally coupled to the pipeline. As described above, and generally known in the art, the cathodic protection system applies a current to the pipeline. The cathodic protection system is conductively coupled to the pipeline. The cathodic protection system has a direct current voltage. The direct current may be supplied by a DC power source or a rectifier, such as a half wave or full wave rectifier. A DC current has a 0 Hz frequency as it is constant. A half wave rectifier typically takes electrical transmission power cable alternating current and converts the alternating current to a DC current at a frequency of about 60 Hz, see figure 6. Similarly, a full wave rectifier typically takes electric transmission power cable alternating current and converts the alternating current to a DC current at a frequency of about 120 Hz, see figure 6. The monitor and process assembly 102, as shown by figure 5, identifies has voltage and current peaks at about 0 Hz, 60 Hz and 120 Hz. Peaks at 60 Hz and 120 Hz may be indicative of either induced current from overhead electrical power transmission cables (in the US) or current from the cathodic protection system. Thus, the peaks (both current and voltage) in the Fourier transformation shown in figure 5 may, or may not, be from induced AC currents.

While the Fourier transformation identifies the frequency(s) of an induced current on the pipeline, the Fourier transformation itself is often insufficient to identify whether the signal is of a true alternating current induced signal. Thus, if a peak is discovered in the Fourier transformation signal, as shown in the figures, the processor further determines if the time domain signal passes through zero. If the signal passes through zero, the analysis is that the induced current (signal) is from an AC source. The monitor and process assembly 102 will typically analyze the sampled time domain signal for the determination.

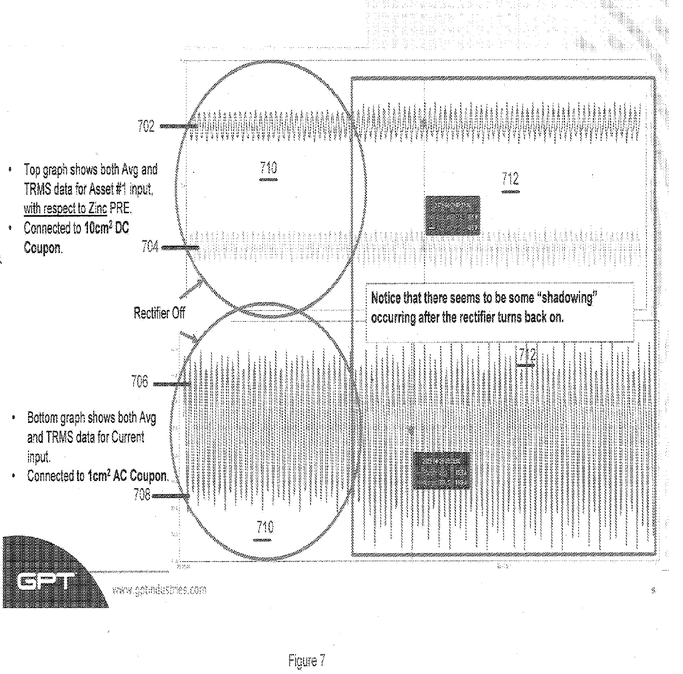

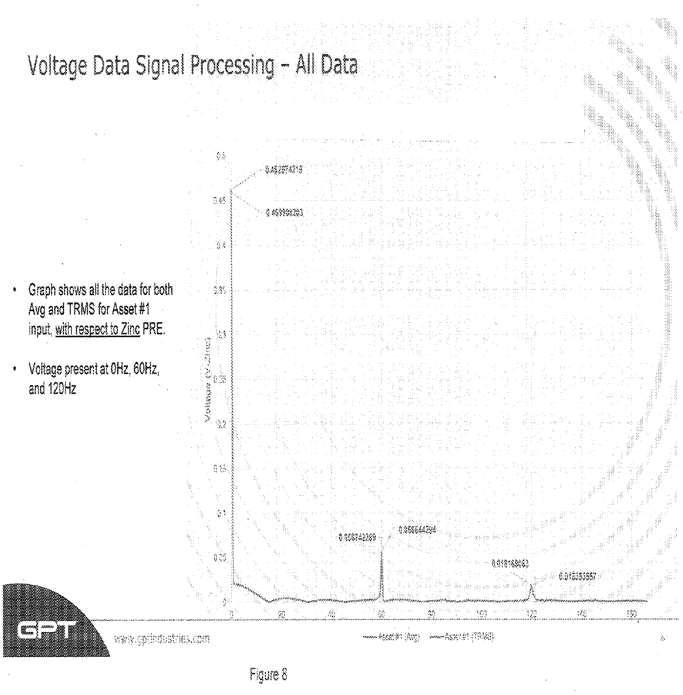

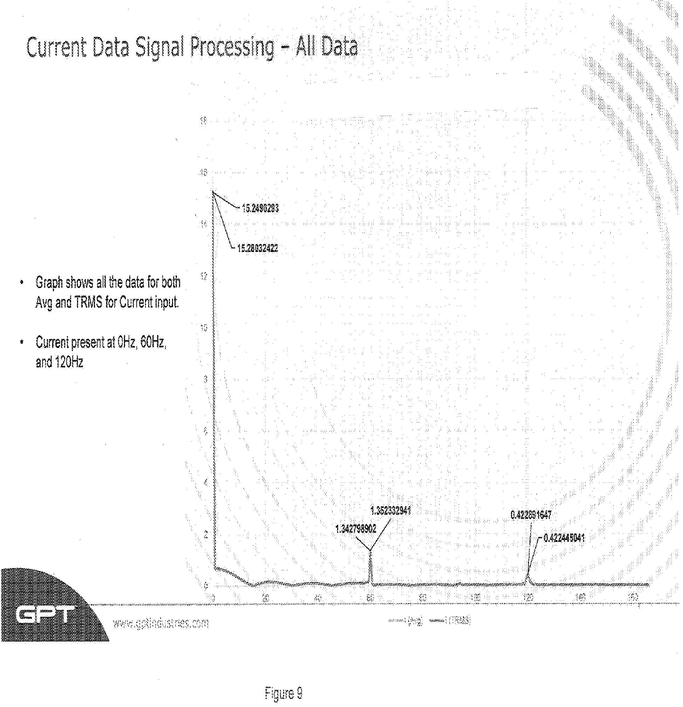

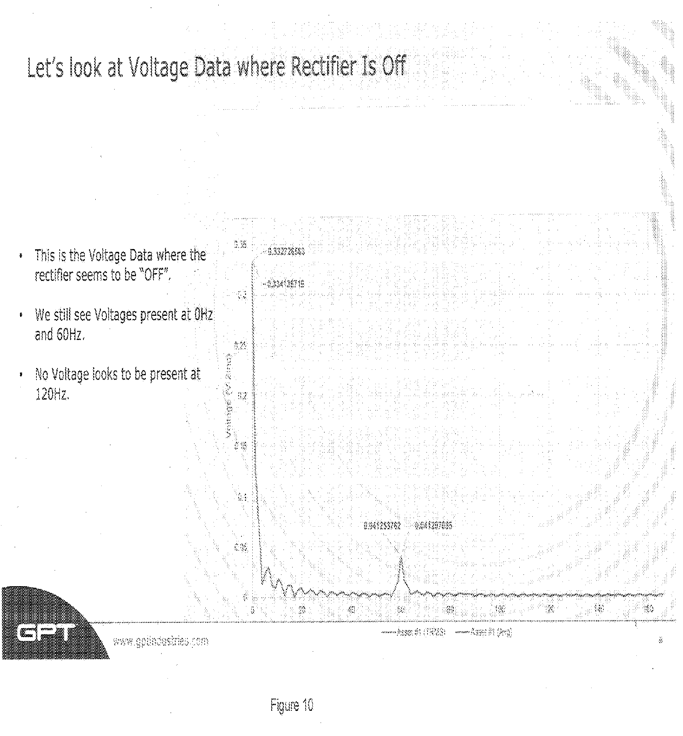

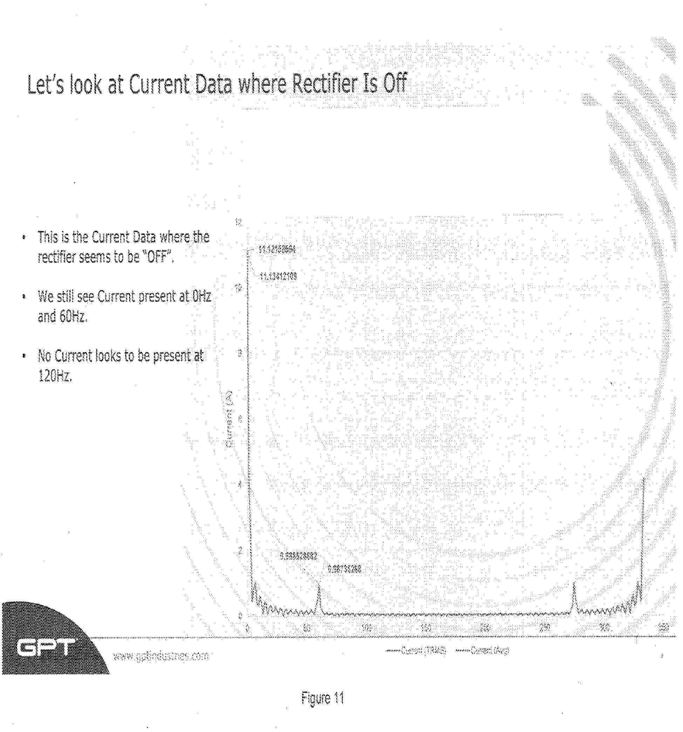

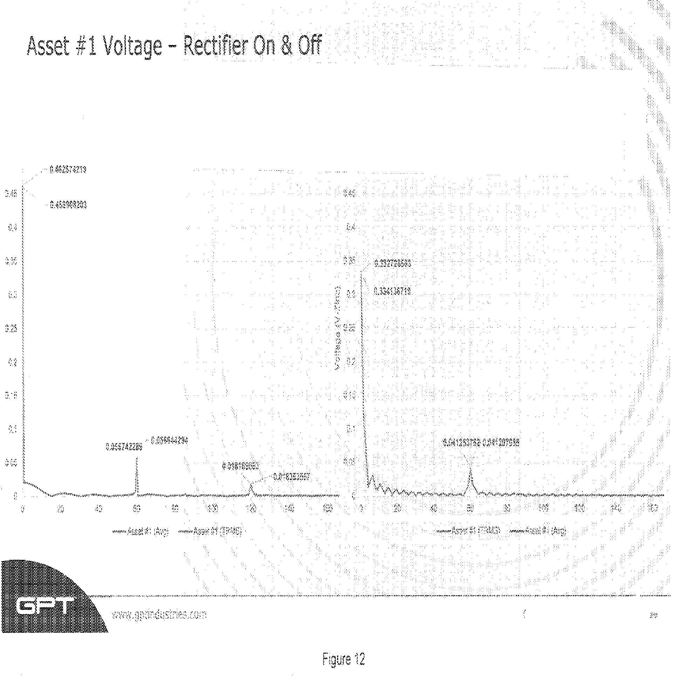

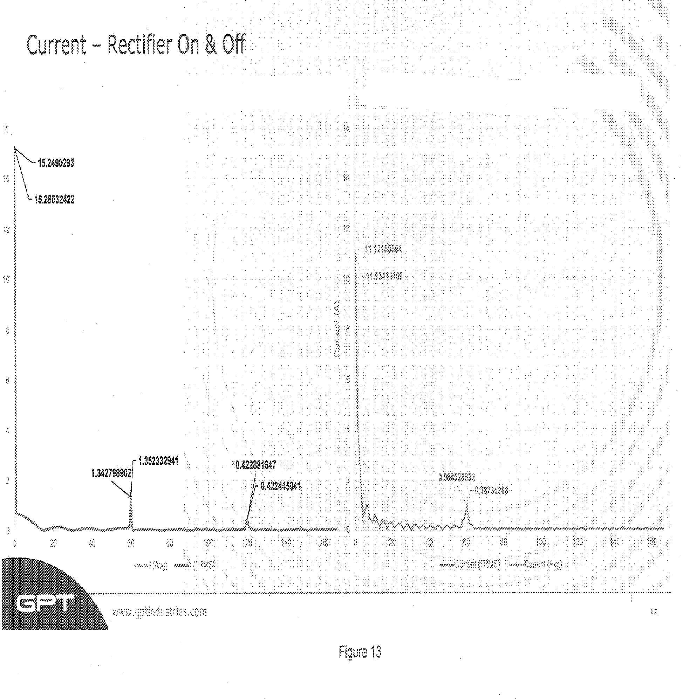

Figures 7-11 show exemplary data where the pipeline has both rectified DC current and induced current. Obtained through the process know to the industry as Instant Off (I-Off). Figure 7 shows a voltage signal with the TRMS voltage data 702, the average voltage value signal 704, and the TRMS current value signal 706 and average current value signal 708, although the signals 706 and 708 are nearly overlapping in values, the difference in the peaks can be seen. The values shown include a rectifier off portion 710 and a rectifier on portion 712. The monitor and process 102 transforms the time domain data to the frequency domain as shown by figures 8 (voltage) and 9 (current) for the rectifier on portion 712. With the rectifier on, figures 8 and 9 show voltage and current peaks at 0 Hz, 60 Hz, and 120 Hz, which as explained above, may be due to the cathodic protection system due to the similarity between overhead (or buried) transmission cable frequency and rectified frequency. Figures 8 and 9 show the peaks for the voltage signals and the current signals from the Fourier transformations at close to 0 Hz, 60 Hz, and 120 Hz, but peaks could be located essentially anywhere on the frequency spectrum depending on the source of the included (or direct) currents. Peaks at other frequencies, however, would generally indicate some induced current on the pipeline without further investigation (or 0 Hz, 50 Hz, or 100 Hz in Europe for example) as the peaks would not be associated with the cathodic protection voltage source. Figures 10 (voltage) and 11 (current) show the Fourier transformation from the monitor and process assembly 102 for when the rectifiers off portion 710. As shown, with the rectifiers off, the Fourier transformation shows peak voltages and currents still occur at both 0 Hz and 60 Hz, but not at 120 Hz. The lack of a peak of 120 Hz indicates the peak at 120 Hz was associated with a full wave rectifier. Noticeably, however, the voltage peaks and current peaks for the rectifier off portion 710 are smaller in magnitude than the voltage peaks and current peaks for the rectifier on portion 712 of the time domain signals shown by figures 7 and 8. However, the peaks for both voltage and current are above a minimum amplitude of, for example, below about 15 VAC and below about 10 mAmps (typically set by the above incorporated safety standards). For example, the NACE current density threshold is 20A/m²; the CEPA threshold is 30A/m² (with an associated AC current to DC current ratio); and the European Standard is presently an AC current desnity of 30A/m² , a DC current density of 1A/m² and an AC current to DC current ratio of 3. All the listed thresholds are subject to change with the associated standards. The mAmp reading is generally a current density that is obtained, in one aspect, through the AC coupon 104 shown in figure 1. Knowing the total contact area of the coupon with the soil and measuring the AC current on the coupon, the monitor and process assembly 102 can calculate the current density. If the peaks were below 15 VAC and 10 mAmps, mitigation would either be not needed or adequate. For comparison, figures 12 and 13 show the frequency domain graphs for the rectifier on portion 712 and rectifier off portion 710 side by side for the voltages and currents. The monitor and process assembly 102 would identify the peaks (and the values of the peaks) as signals due to a distortion on the pipeline. The peak at 60 Hz (in the US/North America) is indicative of an induced current due to electrical power transmission cables. The peak at 0 Hz is typically, but not always, the "true" DC source on the pipeline that may be from galvanic protection systems or through a natural galvanic coupling to the asset. In some aspects, the 0 Hz signal may be from telluric current.. The indication of induced current suggests that AC mitigation is required on the pipeline or the present AC mitigation on the pipeline is not sufficient.

The current density or mAmps may be determined using the coupon 104 coupled to the monitor and process assembly 102 as shown in figure 1. In particular, the coupon's total surface area is known. The current is measurable with the monitor and process assembly 102 as explained above. Thus, the monitor and process assembly 102 can calculate the current density. The Fourier transformation and passing zero analysis may facilitate the density calculations for the AC induced currents.

As mentioned above, the monitoring system 100 uses the monitor and process assembly 102 to take standard readings and scheduled readings. For a standard reading, the monitor and process assembly 102 receives voltage and current signals from the pipeline, step 2. The sample rate is typically set based on the Nyquist theorem. The monitor and process assembly 102 samples the signals, in part with an analog to digital converter, step 4. The monitor and process assembly next processes the samples to calculate the average signal value and the TRMS signal value, step 6. Optionally, the average signal value and the TRMS signal may be saved and displayed on a monitor or GUI of the monitor and process assembly 102 or transmitted to a remote server, which also may be connected to a monitor or GUI to display the values, step 7. The monitor and process assembly 102 determines the ratio of the RMS (or TRMS) signal value/average signal value, step 8. The ratio value is compared to a range (or a value) by the monitor and process assembly to determine whether the signal on the pipeline is distorted, step 10. The signal is considered distorted if the ratio is outside the range (such as, for example, outside of a range from 1.0 to 1.2) or not equal to the value. If the signal is within the range or equal to the value, the monitoring system 100 continues to operate as described. If the signal is outside the range or not equal to the value, the monitor and process assembly 102 may generate a warning, such as, visual or audio indicia that the signal on the pipeline is distorted.

The scheduled readings start similar to the standard readings. The monitor and process assembly 102 receives voltage and current signals from the pipeline, step 22. The monitor and process assembly samples the signals, step 24, and forms a time domain data set or a plurality of time domain data sets for the sampled signal over a period of time. Once the data set is obtained, the monitor and process assembly transforms the time domain data to a frequency domain data set, step 26, using a Fourier transformation or the like. Next, the monitor and process assembly determines whether the frequency data from the data sets have an peaks greater than a predetermined threshold, step 28. The predetermined threshold may be 15 VAC or 10 mAmps (note that greater than may include equal to or greater than), step 28. The frequency domain data may be displayed on a GUI, either on the monitor and process assembly 102 or a remote display unit, such as a smartdevice, or the like. In some cases, the frequency domain data will include data with the rectifier on and the rectifier off as explained above. The monitor and process assembly 102 may generate a warning, such as, visual or audio indicia that the signal on the pipeline is above a threshold (which may include equal to or above the threshold).

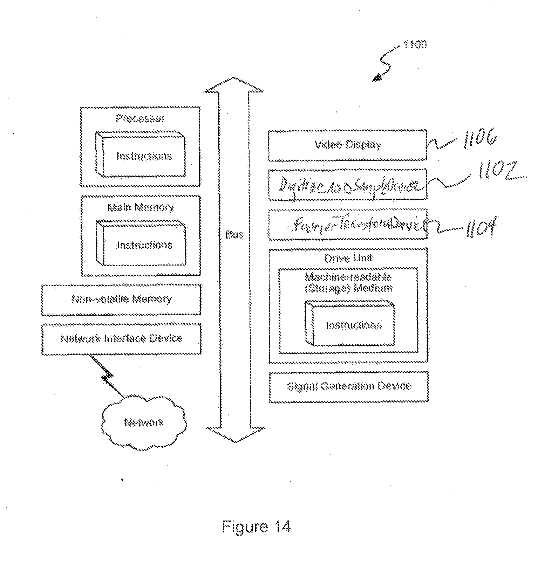

Figure 14 is an exemplary machine 1100 for the monitor and process assembly 102. The exemplary machine 1100 is specially programmed or designed to monitor and process voltage and current signals on the pipeline 108. Given the remote location of many pipelines 108, the machine 1100 is typically a single integrated unit. In certain embodiments, however, the monitor and process assembly 102 may be a number comprise a plurality of networked machines. The machines, as explained below, are shown in figure 14 as a diagrammatic representation of a single machine in the form of a computer system within which a set of instructions for causing the machine to perform any one of the one or more functions and methodologies discussed herein may be executed.

In the example of figure 14, the computer system 1100 includes a processor, memory, non-volatile memory, and an interface device. Various common components (e.g., cache memory) are omitted for illustrative simplicity. The computer system 1100 is intended to illustrate a hardware device on which any of the functions, applications, engines, and scripts are running as described herein and shown in figures (and any other components described in this specification) can be implemented. The computer system 1100 can be of any applicable known or convenient type. The components of the computer system 1100 can be coupled together via a bus or through some other known or convenient device. The machine or computer system 1100 may include a digitize and sample device 1102 specifically configured to sample and digitized the voltage and current signals on the asset 108 using, among other things, an analog to digital converter, which the processor may facilitate by processing instructions in memory. The machine or computer system 1100 further may include a Fourier transformation device 1104. Fourier transformation module that is configured to transform the time domain signal from the digitize and sample device 1102 to the frequency domain. The processor of the machine or computer system 110 determines from the frequency domains whether any voltages or currents are above a minimum threshold (which above a minimum may include equal to or above a minimum threshold). Voltages or currents at a frequency with a peak above the predetermined minimum threshold are determined to be induced currents that require mitigation. The display 1106 is configured to display the information necessary for the functions and operations defined herein including displaying the time domain plots, the frequency domain plot, and any operational signals such as a warning indicia (video - such as a yellow or red signal) indicating the pipeline or asset requires additional mitigation.

The processor may be, for example, a conventional microprocessor such as an Intel microprocessor, Motorola microprocessor, or the like. One of skill in the relevant art will recognize that the terms "machine-readable (storage) medium" or "computer-readable (storage) medium" include any type of device that is accessible by the processor.

The memory is coupled to the processor by, for example, a bus. The memory can include, by way of example but not limitation, random access memory (RAM), such as dynamic RAM (DRAM) and static RAM (SRAM). The memory can be local, remote, or distributed.

The bus also couples the processor to the non-volatile memory and drive unit. The non-volatile memory is often a magnetic floppy or hard disk, a magnetic-optical disk, an optical disk, a read-only memory (ROM), such as a CD-ROM, EPROM, or EEPROM, a magnetic or optical card, or another form of storage for large amounts of data. Some of this data is often written, by a direct memory access process, into memory during execution of software in the computer 1100. The non-volatile storage can be local, remote, or distributed. The non-volatile memory is optional because systems can be created with all applicable data available in memory. A typical computer system will usually include at least a processor, memory, and a device (e.g., a bus) coupling the memory to the processor.

Software is typically stored in the non-volatile memory and/or the drive unit. Indeed, for large programs, it may not even be possible to store the entire program in the memory. Nevertheless, it should be understood that for software to run, if necessary, it is moved to a computer readable location appropriate for processing, and for illustrative purposes, that location is referred to as the memory in this paper. Even when software is moved to the memory for execution, the processor will typically make use of hardware registers to store values associated with the software, and local cache that, ideally, serves to speed up execution. As used herein, a software program is assumed to be stored at any known or convenient location (from non-volatile storage to hardware registers) when the software program is referred to as "implemented in a computer-readable medium". A processor is considered to be "configured to execute a program" when at least one value associated with the program is stored in a register readable by the processor.

The bus also couples the processor to the network interface device. The interface can include one or more of a modem or network interface. It will be appreciated that a modem or network interface can be considered to be part of the computer system. The interface can include an analog modem, isdn modem, cable modem, token ring interface, satellite transmission interface (e.g. "direct PC"), or other interfaces for coupling a computer system to other computer systems. The interface can include one or more input and/or output devices. The I/O devices can include, by way of example but not limitation, a keyboard, a mouse or other pointing device, disk drives, printers, a scanner, and other input and/or output devices, including a display device. The display device can include, by way of example but not limitation, a cathode ray tube (CRT), liquid crystal display (LCD), or some other applicable known or convenient display device. For simplicity, it is assumed that controllers of any devices not depicted reside in the interface.

In operation, the computer system 1100 can be controlled by operating system software that includes a file management system, such as a disk operating system. One example of operating system software with associated file management system software is the family of operating systems known as Windows^{®} from Microsoft Corporation of Redmond, Washington, and their associated file management systems. Another example of operating system software with its associated file management system software is the Linux operating system and its associated file management system. The file management system is typically stored in the non-volatile memory and/or drive unit and causes the processor to execute the various acts required by the operating system to input and output data and to store data in the memory, including storing files on the non-volatile memory and/or drive unit.

Although the technology has been described in language that is specific to certain structures and materials, it is to be understood that the invention defined in the appended claims is not necessarily limited to the specific structures and materials described. Rather, the specific aspects are described as forms of implementing the claimed invention. Because many embodiments of the invention can be practiced without departing from the spirit and scope of the invention, the invention resides in the claims hereinafter appended. Unless otherwise indicated, all numbers or expressions, such as those expressing dimensions, physical characteristics, etc. used in the specification (other than the claims) are understood as modified in all instances by the term "approximately." At the very least, and not as an attempt to limit the application of the doctrine of equivalents to the claims, each numerical parameter recited in the specification or claims which is modified by the term "approximately" should at least be construed in light of the number of recited significant digits and by applying ordinary rounding techniques. Moreover, all ranges disclosed herein are to be understood to encompass and provide support for claims that recite any and all subranges or any and all individual values subsumed therein. For example, a stated range of 1 to 10 should be considered to include and provide support for claims that recite any and all subranges or individual values that are between and/or inclusive of the minimum value of 1 and the maximum value of 10; that is, all subranges beginning with a minimum value of 1 or more and ending with a maximum value of 10 or less (e.g., 5.5 to 10, 2.34 to 3.56, and so forth) or any values from 1 to 10 (e.g., 3, 5.8, 9.9994, and so forth).

## Claims

1. A method comprising,
receiving at a monitor and process assembly a first signal indicative of at least a voltage or current on a pipeline;
calculating, by the monitor and process assembly, a root mean square of the first signal; calculating, by the monitor and process assembly, an average of the first signal; collecting at least a first time domain data set of the root mean square and the average of the first signal data set that at least meets the Nyquist theorem and performing a Fourier Transform (FT);
performing an analysis on the same data set to determine if the signal(s) pass through zero to determine if the signal(s) are from an AC source;
transforming, by the monitor and process assembly, the first time domain data set to a first frequency domain data set; and
displaying the first frequency domain data set.

2. The method of claim 1 wherein the monitor and process assembly receives a second signal indicative of the other of the voltage or current on the pipeline, comprising:
calculating, by the monitor and process assembly, a root mean square of the second signal;
calculating, by the monitor and process assembly, an average of the second signal;
collecting at least a second time domain data set of the root mean square and the average of the second signal;
transforming, by the monitor and process assembly, the second time domain data set to a second frequency domain data set; and
displaying the second frequency domain data set.

3. The method of claim 2 wherein the monitor and process assembly determines whether a peak of the first frequency domain data set or the second frequency domain data set is greater than or equal to a threshold.

4. The method of claim 3 wherein the monitor and process assembly determines whether the peak of the first frequency domain data set or the second frequency domain data set is just greater than the threshold.

5. The method of claim 3 or 4 wherein the threshold is at least 15 VAC and 10 mAmps.

6. The method of any one of the preceding claims comprising,
determining a first ratio, wherein the first ratio is the root mean square/the average of the first signal.

7. The method of any one of the preceding claims comprising,
determining a second ratio, wherein the second ratio is the root mean square/the average of the second signal.

8. The method of any one of the preceding claims wherein the root mean square is the true root mean square.

9. A monitoring system for identifying currents on a pipeline, the system comprising a monitor and process assembly configured to receive signals from a pipeline, the monitor and process assembly comprising:
a receiver configured to receive a first signal indicative of at least one of a voltage or a current from a pipeline;
a processor and memory configured to perform the following functions:
calculating a root mean square of the first signal;
calculating an average of the first signal;
collecting at least a first time domain data set of the root mean square and the average of the first signal
transforming, by the monitor and process assembly, the first time domain data set to a first frequency domain data set; and
displaying the first frequency domain data set.

10. The monitoring system of claim 9 wherein transforming the first time domain data set to a first frequency domain data set comprises a Fourier transform.

11. The monitoring system of claim 10 wherein the Fourier transform is a fast Fourier transform.

12. The monitoring system of any one of claims 9 to 11 wherein the first-time domain data set meets the Nyquist theorem.

13. The monitoring system of any one of claims 9 to 12 wherein the processor determines whether a peak of the first frequency domain data set exceed a threshold.

14. The monitoring system of claim 13 wherein the threshold is at least one of 15 VAC or 10 mAmps.
